(19) Europäisches Patentamt
European Patent Office
Office européen des brevets

(11) **EP 4 571 337 A1**

(12) **EUROPEAN PATENT APPLICATION**

(43) Date of publication:
**18.06.2025 Bulletin 2025/25**

(21) Application number: **24169683.0**

(22) Date of filing: **11.04.2024**

(51) International Patent Classification (IPC):
*G01R 31/367* (2019.01)    *G01R 31/3842* (2019.01)
*G01R 31/389* (2019.01)    *G01R 31/392* (2019.01)
*G01R 31/396* (2019.01)    *H01M 10/48* (2006.01)
*H02J 7/00* (2006.01)

(52) Cooperative Patent Classification (CPC):
**H01M 10/48; G01R 31/367; G01R 31/3842;
G01R 31/389; G01R 31/392; G01R 31/396;
H01M 10/482; H02J 7/0048**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **11.12.2023 KR 20230178975**

(71) Applicant: **Samsung SDI Co., Ltd.
Yongin-si, Gyeonggi-do 17084 (KR)**

(72) Inventor: **Alekseev, Aleksandr
16678 Suwon-si, Gyeonggi-do (KR)**

(74) Representative: **Gulde & Partner
Patent- und Rechtsanwaltskanzlei mbB
Berliner Freiheit 2
10785 Berlin (DE)**

(54) **APPARATUS AND METHOD FOR CALCULATING BATTERY ENERGY**

(57) An apparatus for calculating battery energy includes a memory storing relationship information between a stepwise state of charge (SOC) of a battery device and a plurality of battery characteristic information corresponding to each stepwise SOC, and a processor operatively coupled to the memory. The processor calculates target SOCs, each defined for preset nodes, target battery characteristic information, each defined for the nodes, based on the relationship information stored in the memory and the calculated target SOCs, target powers, each defined for the nodes, from the calculated target battery characteristic information, and energy of the battery device using a weighted sum method with respect to the target powers calculated. A corresponding method and computer-readable storage medium are also provided.

## FIG. 4

| Calculate target SOC, target OCV, and target resistance value | — S100 |
| Calculate target power | — S200 |
| Calculate time–scale parameter | — S300 |
| Calculate battery energy | — S400 |
| Derive and display drivable range | — S500 |

# EP 4 571 337 A1

## Description

BACKGROUND

1. Field

The present disclosure relates to an apparatus and method for calculating battery energy.

2. Description of the Related Art

Energy stored in a battery (for example, a lithium-ion battery), hereinafter referred to as "battery energy", is defined as the cumulative power of the battery when the battery is discharged from a defined maximum state of charge (SOC) to a defined minimum SOC and is an indicator of performance of the battery. Battery energy is directly related to a range which an electric vehicle can travel when the battery is fully or partially charged, in which a charge level of the battery is defined as the SOC. In addition, the battery energy is also used as a measurement of the state of health (SOH), which is a ratio between stored energy in a current state and energy defined for a fresh battery cell at the beginning of life (BOL), and the end of life (EOL) condition of the battery may be defined based on the battery energy.

A discharge method applied to measurement of battery energy is implemented through standard profiles, such as the Worldwide Harmonized Light Vehicles Test Procedure (WLTP) or Urban Dynamometer Driving Schedule (UDDS), or through specific profiles, such as constant power or constant current. The battery energy is calculated as an integral value of power extracted from the battery upon discharge of the battery according to the discharge method described above at a specific temperature and within a specific SOC range. A common approach to calculation of the battery energy is to perform discharge tests at various SOHs of the battery, followed by recording test results in a lookup table or finding an appropriate fitting function. However, this approach is complex, time-consuming, and dependent on specific test data. Moreover, when test conditions are changed, it is inconvenient to repeat all necessary tests again. Therefore, it is desirable to improve on the common approach for calculation of the battery energy.

## SUMMARY

Embodiments include an apparatus for calculating battery energy. The apparatus includes a memory storing relationship information between a stepwise state of charge (SOC) of a battery device and a plurality of battery characteristic information corresponding to each stepwise SOC, and a processor operatively coupled to the memory. The processor calculates a plurality of target SOCs, each defined for a preset plurality of nodes, a plurality of target battery characteristic information, each defined for the plurality of nodes, based on the relationship information stored in the memory and the calculated plurality of target SOCs, a plurality of target powers, each defined for the plurality of nodes, from the calculated plurality of target battery characteristic information, and energy of the battery device using a weighted sum method with respect to the plurality of target powers calculated.

The battery characteristic information includes a stepwise open circuit voltage (OCV) and a stepwise resistance value corresponding to each stepwise SOC, and the relationship information may define a relationship between the stepwise SOC, the stepwise OCV, and the stepwise resistance value.

The processor may calculate the energy of the battery device by simulating a process of changing the SOC of the battery device from a first SOC to a second SOC.

Each of the nodes may be assigned predefined setpoints to optimize the energy of the battery device calculated in the weighted sum method.

The processor may apply the setpoints to a function with the first SOC, the second SOC, and the nodes as arguments to calculate the target SOCs, and apply the calculated target SOCs to the relationship information to calculate target OCVs, each defined for the nodes, and target resistance values, each defined for the nodes.

The processor may calculate the target resistance values based on the relationship information and a resistance degradation parameter indicating a degree of resistance degradation of the battery device.

The processor may calculate the target powers, each defined for the nodes, based on the target OCVs, the target resistance values, and a current parameter applied to change the SOC of the battery device from the first SOC to the second SOC.

The processor may calculate a capacity of the battery device, a current parameter applied to change the SOC of the battery device from the first SOC to the second SOC, a capacity degradation parameter indicating a degree of capacity degradation of the battery device, and a time-scale parameter applied to the weighted sum method based on the first and second SOCs.

The processor may calculate the energy of the battery device by applying the time-scale parameter to a result value obtained through application of the weighted sum method to the plurality of target powers.

Each of the nodes may be assigned predefined setpoints to optimize the energy of the battery device calculated according to the weighted sum method, and the setpoints assigned to the nodes and weights applied to the weighted sum method may have a relationship according to a predefined rule.

The battery device may be realized by a single battery cell, and, when a battery structure of nS battery cells connected in series or nP battery cells connected in parallel may be defined as a battery system, wherein nS and nP are natural numbers greater than or equal to 2, the processor may apply at least one of nS and nP values to the calculated energy of the battery device to calculate a total energy of the battery system.

The relationship information may be obtained and stored in the memory based on a result of a test performed on the battery device at a particular temperature and may include relationship information based on results of tests performed at various temperatures, and the processor may read the relationship information corresponding to a currently set temperature from the memory to calculate the energy of the battery device.

Embodiments include a method of calculating battery energy. The method includes calculating, by a processor, target SOCs, each defined for a predetermined set of nodes, and target battery characteristic information, each defined for the nodes and based on the calculated target SOCs and relationship information, the relationship information defining a relationship between a stepwise state of charge (SOC) of a battery device and battery characteristic information corresponding to each stepwise SOC, calculating, by the processor, target powers, each defined for the nodes, from the calculated target battery characteristic information, and calculating, by the processor, energy of the battery device using a weighted sum method for the calculated target powers.

The battery characteristic information may include a stepwise open circuit voltage (OCV) and a stepwise resistance value corresponding to each stepwise SOC; and the relationship information may define a relationship between the stepwise SOC, the stepwise OCV, and the stepwise resistance value.

The processor may calculate the energy of the battery device by simulating a process of changing the SOC of the battery device from a first SOC to a second SOC, and each of the nodes may be assigned predefined setpoints to optimize the energy of the battery device calculated in the weighted sum method.

Calculating target SOCs and target battery characteristic information, the processor may apply the setpoints to a function with the first SOC, the second SOC, and the nodes as arguments to calculate the target SOCs, and may apply the calculated target SOCs to the relationship information to calculate target OCVs, each defined for the nodes, and target resistance values, each defined for the nodes.

The processor may calculate the target powers, each defined for the nodes, based on the target OCVs, the target resistance values, and a current parameter applied to change the SOC of the battery device from the first SOC to the second SOC.

The method of calculating battery energy may further include calculating, by the processor, a capacity of the battery device, a current parameter applied to change the SOC of the battery device from the first SOC to the second SOC, a capacity degradation parameter indicating a degree of capacity degradation of the battery device, and a time-scale parameter applied to the weighted sum method based on the first and second SOCs.

The processor may calculate the energy of the battery device by applying the time-scale parameter to a result value obtained through application of the weighted sum method to the target powers.

Embodiments include a computer program recorded in a computer-readable storage medium to execute, in combination with hardware calculating target SOCs, each defined for a predetermined set of nodes, and target battery characteristic information each defined for the nodes and based on the calculated target SOCs and relationship information, the relationship information defining a relationship between a stepwise state of charge (SOC) of a battery device and battery characteristic information corresponding to each stepwise SOC, calculating target powers, each defined for the nodes, from the calculated target battery characteristic information, and calculating energy of the battery device using a weighted sum method for the calculated target powers.

In accordance with an aspect of the present invention, there is provided an apparatus and method for calculating battery energy, which calculates target power based on target SOC, target OCV, and target resistance values defined for a plurality of nodes, followed by adding a weighted sum for the calculated target power to calculate battery energy.

The apparatus and method according to the present invention eliminate test complexity, time-consumption, and test data dependency associated with a typical method for calculating battery energy by calculating battery energy based on a simple and improved model.

BRIEF DESCRIPTION OF THE DRAWINGS

Features will become apparent to those of skill in the art by describing in detail exemplary embodiments with reference to the attached drawings in which:

FIG. 1 is a block diagram of an apparatus for calculating battery energy according to one or more embodiments;
FIG. 2 is a diagram illustrating battery characteristic information in the apparatus for calculating battery energy according to one or more embodiments;

FIGS. 3A to 3D are graphs illustrating an error rate of battery energy calculated through the apparatus for calculating battery energy according to one or more embodiments;

FIG. 4 is a flowchart illustrating a method of calculating battery energy according to one or more embodiments.

DETAILED DECSRIPTION

Example embodiments will now be described more fully hereinafter with reference to the accompanying drawings. In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

The terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof. Further, the use of "may" when describing embodiments of the present invention relates to "one or more embodiments of the present invention."

Although the terms first, second, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Throughout the specification, unless otherwise stated, each element may be singular or plural.

In addition, when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

In the following embodiments, a battery device refers to a single battery cell and battery energy refers to accumulated energy, i.e., the integral value of power discharged from the battery of the battery device , i.e., residual energy of the battery device, when the battery device , i.e., the battery cell, is discharged within certain temperature and SOC ranges, which are set according to user input to an input module 100 described below.

The embodiments herein focus on a process of calculating battery energy using experimental data obtained in advance through discharge testing on a battery device and battery parameters (described below) set by a user rather than a process of calculating the battery energy through a physical discharge test on the battery device. However, the energy derived from discharge testing according to a typical worldwide harmonized light vehicles test procedure (WLTP) profile or a constant current profile may be used as a reference for determining reliability of battery energy calculated by a processor 400 according to one or more embodiments.

As used herein, the term "target" is adopted to clarify that it corresponds to a parameter directly considered in calculation of battery energy and the term "step" is adopted to clarify that it corresponds to a parameter utilized to derive the "target" parameter.

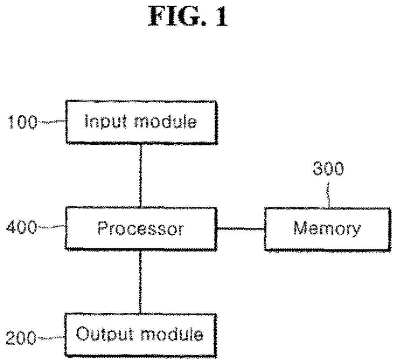

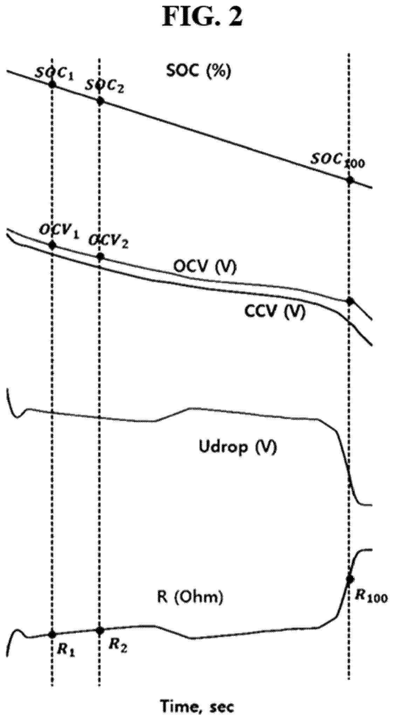

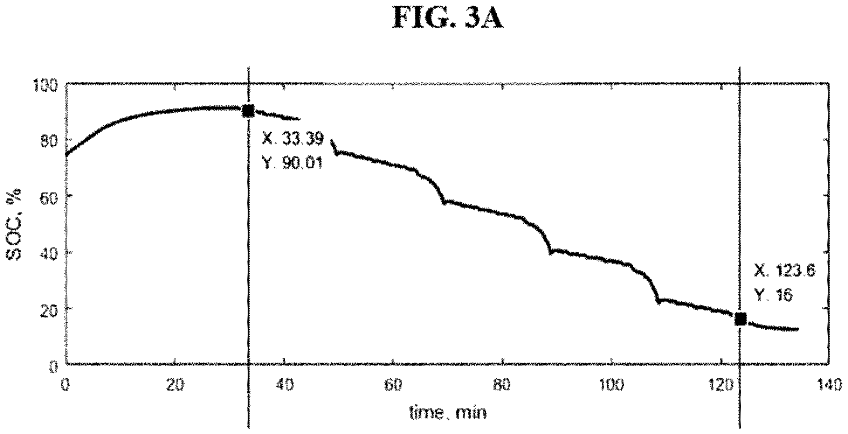

FIG. 1 is a block diagram of an apparatus for calculating battery energy according to one or more embodiments. FIG. 2 is a diagram illustrating battery characteristic information in the apparatus for calculating battery energy according to embodiments. FIG. 3A to FIG. 3D are graphs illustrating an error rate of battery energy calculated through the apparatus for calculating battery energy according to embodiments.

Referring to FIG. 1, an apparatus for calculating battery energy according to one or more embodiments may include an input module 100, an output module 200, a memory 300, and a processor 400.

The input module 100 may receive parameters, referred to herein as "battery parameters", which are used by the processor 400 to calculate battery energy, from a user. The input module 100 may be realized by a computing device (for example, a PC or a mobile device) that provides a user interface (UI) for receiving the battery parameters. The battery parameters input through the input module 100 may be transmitted to the processor 400 through wired communication, such as UART, CAN, Ethernet LAN, SPI or I2C, or through wireless communication, such as WI-FI, Bluetooth, and the like.

The battery parameters input through the input module 100 may include: i) a first SOC (maximum SOC), ii) a second SOC (minimum SOC), iii) a current parameter applied to change the SOC from the first SOC to the second SOC, iv) a temperature at which the battery energy is calculated, v) a capacity degradation parameter indicating the degree of capacity degradation of the battery device, vi) a resistance degradation parameter indicating the degree of resistance degradation of the battery device, vii) the number of battery devices connected in series, and viii) the number of battery devices connected in parallel.

In this example embodiment, the battery energy may be calculated by a method that simulates the process of changing the SOC of a device. The first SOC ($SOC_{MAX}$) and the second SOC ($SOC_{MIN}$) described above define the maximum value and the minimum value of the range in which the SOC is changed, respectively. The first SOC has a greater value than the second SOC.

The current parameter ($I_D$) is a discharge current drawn from the battery to allow the change from the first SOC ($SOC_{MAX}$) to the second SOC ($SOC_{MIN}$) and is provided as an average over time.

The temperature (Temp) is a temperature of an environment in which battery energy is derived or extracted from the battery.

The capacity degradation parameter (facQ) is a parameter indicating the SOH of a capacity of the battery device and is defined as the ratio of the capacity ($Q_{cur}$) at the current time to the capacity ($Q_{bol}$) at the beginning of life (BOL) of the battery device, which may be related by facQ = $Q_{cur}$ /$Q_{bol}$ * 100.

The resistance degradation parameter is a parameter indicating the SOH of direct current internal resistance (DCIR), hereafter referred to as a "resistance value" of the battery device and is defined as the ratio of the resistance value ($R_{cur}$) at the current time to the resistance value ($R_{bol}$) at the beginning of life (BOL) of the battery device, which may be related by facR = $R_{cur}$ /$R_{bol}$ * 100.

The number of battery devices connected in series (nS) and the number of battery devices connected in parallel (nP) are parameters used to calculate the total energy of a battery system. In an example embodiment, if both nS and nP have a value of 1, the energy of a single battery cell may be calculated, and if nS or nP has a value of 2 or more, the energy of a battery module or a battery pack may be calculated. Accordingly, nS and nP function as parameters that determine whether a target for calculation of battery energy is a battery cell, a battery module, or a battery pack.

Symbols and units of the above battery parameters are set in accordance with the following Table 1 and the symbols and units in Table 1 are applied consistently throughout this specification.

Table 1

| Battery parameter | Symbol | Unit |
|---|---|---|
| First SOC | $SOC_{MAX}$ | % |
| Second SOC | $SOC_{MIN}$ | % |
| Current parameter | $I_D$ | A |
| Temperature | Temp | °C |
| Capacity degradation parameter | facQ | % |
| Resistance degradation parameter | facR | % |
| Number of battery devices connected in series | nS | - |
| Number of battery devices connected in parallel | nP | - |

The output module 200 may display the battery energy calculated by the processor 400 and may be realized by a computing device (for example, a PC or a mobile device) that provides a user interface (UI) for displaying the battery energy. The battery energy calculated by the processor 400 may be transmitted to the output module 200 through wired communication, such as a UART, CAN, Ethernet LAN, SPI or I2C, or through wireless communication, such as WI-FI, Bluetooth, and the like, to be displayed thereon.

The memory 300 may store data and applications (programs or applets) related to operation of calculating battery energy by the processor 400 and an operating system for operating the processor 400, and information stored in the memory 300 may be selected by the processor 400, as needed. The memory 300 may be realized by a non-volatile storage device, for example, non-volatile memory (NVM), an SSD/HDD storage, an SD card, a magnetic storage medium, a flash storage medium, or the like, and may be connected to the processor 400 through wired communication, such as UART, CAN, Ethernet LAN, SPI or I2C, or through wireless communication, such as WI-FI, Bluetooth, and the like.

To calculate battery energy, the memory 300 may store relationship information between a stepwise state of charge (SOC) of the battery device (in an example embodiment, multiple SOCs having a step of 1%) and battery characteristic information corresponding to each stepwise SOC, wherein the battery characteristic information may include a stepwise open circuit voltage (OCV) and a stepwise resistance value corresponding to each stepwise SOC. Accordingly, the relationship information refers to information defining a relationship between each stepwise SOC, each stepwise OCV, and each stepwise resistance value.

The relationship information may be based on experimental data obtained through discharge testing on the battery device. In this example embodiment, the discharge testing may employ the well-known Galvano-static intermittent titration technique (GITT) test described with respect to FIG. 2, wherein a battery device placed in a temperature chamber is charged to a SOC of 100% and then discharged to a SOC of 0% with the temperature thereof stabilized at a particular temperature. By the GITT test, a datasheet of the battery device , i.e., a battery cell, may be obtained in advance and may define a function for calculating the OCV corresponding to a particular SOC (referred hereinafter as "first function") and a capacity (Q(Ah)) of the battery cell. From such a datasheet, the SOC, OCV, and resistance value (R) of the battery device can be calculated according to the following Equation 1.

<Equation 1>

$$SOC(t) = \frac{1}{a \cdot Q} \int I_c \, dt = \frac{I_c}{a \cdot Q} t + SOC(0)$$
$$OCV(t) = F_{OCV}(SOC(t))$$
$$CCV(t) = Ucell(t)$$
$$Udrop(t) = Ucell(t) - OCV(t)$$
$$R(t) = \frac{Ucell(t) - OCV(t)}{I_c}$$

In Equation 1, t may have units of seconds [sec], which applies equally to all subsequent equations, $I_c$ is a discharge current which has unit of Amperes or Amps [A], Q is a capacity of a battery cell, which has units of Ampere hours [Ah], and "a" is a unit conversion constant, which has a value of 36. $F_{OCV}$ () is a first order function to calculate an OCV corresponding to a specific SOC. CCV denotes a closed circuit voltage, Ucell denotes a cell voltage, and Udrop denotes a voltage drop across a battery cell.

Based on Equation 1, each stepwise SOC, the stepwise OCV and the stepwise resistance value R corresponding to each stepwise SOC may be calculated to create a lookup table of relationship information. Multiple SOCs may be reflected in the lookup table and may have a grid of 1% steps and, thus, the lookup table may define a matching relationship between the SOC for each step of 1%, the stepwise OCV and the stepwise resistance value R corresponding to each stepwise SOC.

Once the lookup table is established, a function (hereinafter, "second function") for calculating a resistance value R corresponding to a particular SOC may be defined. As will be described in more detail below, the SOC, OCV, and resistance value utilized to calculate the battery energy in this example embodiment correspond to target values defined for a predetermined set of nodes rather than values for each step in the lookup table. A target OCV corresponding to a particular target SOC may be derived through the first function described above, and since obtaining a target resistance value from the particular target SOC requires a function for converting the particular SOC to the particular resistance value, i.e., the second function, such a second function may be derived, in one or more embodiments, by a designer based on the lookup table and predefined in the memory 300. An analysis method applied to derive the second function from the lookup table may be a regression analysis method known in the art, such as linear regression analysis or polynomial regression analysis.

Accordingly, the lookup table recording the matching relationship between the stepwise SOC, the stepwise OCV and the stepwise resistance value R, the first function for calculating an OCV corresponding to a particular SOC, and the second function for calculating a resistance value R corresponding to the particular SOC may be stored as the relationship information in the memory 300.

In some embodiments, the relationship information, i.e., the lookup table and the first and second functions, may be obtained in plural and stored in the memory 300 based on results of tests (for example, GITT tests) performed on the battery device at various temperatures.

The processor 400 is the entity that calculates battery energy. The processor 400 may be realized by a central processing unit (CPU), a system-on-chip (SoC), or the like, may run an operating system or application to control hardware and/or software components connected to the processor 400, and may perform various data processing and computation. The processor 400 may be configured to execute at least one instruction stored in the memory 300 and store data resulting from the execution in the memory 300.

In some embodiments, the processor 400 may be realized by a vehicular controller (for example, a battery management system or BMS) to derive a drivable range of a vehicle based on battery energy calculated through a process described below and display the drivable range through the output module 200 such that a user can recognize the drivable range of the vehicle at the current time. To this end, a lookup table or function defining a relationship between the battery energy and the drivable range of the vehicle may be previously stored in the memory 300.

To calculate the battery energy, the processor 400 may: (i) calculate target SOCs, each defined for a predetermined set of nodes, and to calculate target battery characteristic information, each defined for the nodes based on the relationship information stored in the memory 300 and the calculated target SOCs; (ii) calculate target powers, each defined for the nodes, from the calculated target battery characteristic information, and (iii) calculate energy of the battery device through application of a weighted sum method to the calculated target powers.

Such operation of the processor 400 is based on the Gauss-Legendre Quadrature Rule. As well-known in the art, the Gauss-Legendre Quadrature Rule is a rule for approximating a definite integral of a function in numerical analysis, which can be expressed as the following Equation 2:

<Equation 2>

$$\int_\alpha^\beta f(x)\,dx \approx \sum_{i=1}^{n} w_i f(x_i),$$

where $x_i$ is a quadrature node, $w_i$ is a quadrature weight, and n is the number of sample points.

This example embodiment focuses on the process of calculating energy of a battery device based on the relationship information stored in the memory 300 and the Gauss-Legendre Quadrature Rule according to Equation 2. The nodes $x_i$, the weight $w_i$, and the target power $P_{xi}$ correspond to the quadrature nodes, the quadrature weight and the function f of the Gauss-Legendre Quadrature Rule according to Equation 2, respectively.

First, the processor 400 may calculate target SOCs ($SOC_{xi}$), each defined for a predetermined set of nodes ($x_i$), and may calculate target OCVs ($OCV_{xi}$) and target resistance values ($R_{xi}$), each defined for the nodes ($x_i$), based on the relationship information stored in the memory 300 and the calculated target SOCs ($SOC_{xi}$).

As described above, the nodes ($x_i$) may correspond to the quadrature nodes of the Gauss-Legendre Quadrature Rule, and the number (n) of nodes ($x_i$) may be predefined as a value for optimizing the energy of the battery device, i.e., minimizing an error in calculated battery energy (in an example embodiment, n = 5). Further, each of the nodes ($x_i$) may be assigned predefined setpoints to optimize the energy of the battery device, and according to the Gauss-Legendre Quadrature Rule, the setpoint for each node is shown in Table 2 (in this example embodiment, n = 5).

Table 2

| $x_i$ | Node setpoint |
|---|---|
| $x_1$ | 0 |
| $x_2$ | -0.538469310105683 |
| $x_3$ | 0.538469310105683 |
| $x_4$ | -0.906179845938664 |
| $x_5$ | 0.906179845938664 |

Based on the configuration and setpoints of the nodes as shown in Table 2, the processor 400 may apply the setpoints to a function with a first SOC ($SOC_{MAX}$), a second SOC ($SOC_{MIN}$), and a node ($x_i$) as arguments to calculate target SOCs ($SOC_{xi}$), which may be expressed according to Equation 3:

<Equation 3>

$$SOC_{xi} = \frac{SOC_{MAX} - SOC_{MIN}}{2} x_i + \frac{SOC_{MAX} + SOC_{MIN}}{2}.$$

In an example embodiment where the number (n) of nodes ($x_i$) is 5, each of five setpoints shown in Table 2 may be substituted into the right side of Equation 3 to calculate five target SOCs ($SOC_{x1}$, $SOC_{x2}$, $SOC_{x3}$, $SOC_{x4}$, $SOC_{x5}$).

Once the target SOCs are calculated, the processor 400 may apply the first function described above, i.e., the function for converting a particular SOC to a particular OCV, to each of the target SOCs ($SOC_{xi}$) calculated according to Equation 3 to calculate the target OCVs ($OCV_{xi}$), which may be expressed as shown in Equation 4:

<Equation 4>

$$OCV_{xi} = F_{OCV}(SOC_{xi}),$$

where $F_{OCV}()$ represents the first function.

In an example embodiment, if the number (n) of nodes ($x_i$) is 5, the five target SOCs ($SOC_{x1}$, $SOC_{x2}$, $SOC_{x3}$, $SOC_{x4}$, $SOC_{x5}$) may be substituted into the right side of Equation 3 to calculate five target OCVs ($OCV_{x1}$, $OCV_{x2}$, $OCV_{x3}$, $OCV_{x4}$, $OCV_{x5}$).

Further, the processor 400 may calculate target resistance values ($R_{xi}$) by applying the resistance degradation parameter of Table 1 to a resulting value obtained by applying target SOCs ($SOC_{xi}$) to the second function, i.e., the function for converting a particular SOC to a particular resistance value as described above. Since the second function corresponds to a theoretical function defined based on Equation 1 and the lookup table in the memory 300, and the degree of resistance degradation of an actual battery device is not reflected in the second function, the processor 400 may calculate the target resistance values ($R_{xi}$) by applying the resistance degradation parameter (facR) to the resulting value obtained by applying the target SOCs ($SOC_{xi}$) to the second function, in order to calculate more accurate target resistance values reflecting the degree of resistance degradation of the actual battery device. The target resistivity values ($R_{xi}$) may be calculated according to Equation 5:

<Equation 5>

$$R_{xi} = R(SOC_{xi}) \cdot facR/b,$$

where R() represents the second function and b is a unit conversion constant and has a value of 100.

In an example embodiment in which the number (n) of nodes ($x_i$) is 5, the five target SOCs ($SOC_{x1}$, $SOC_{x2}$, $SOC_{x3}$, $SOC_{x4}$, $SOC_{x5}$) may be substituted into the right side of Equation 5 to calculate five target resistance values ($R_{x1}$, $R_{x2}$, $R_{x3}$, $R_{x4}$, $R_{x5}$).

Once the target OCVs ($OCV_{xi}$) and the target resistance values ($R_{xi}$) are calculated according to Equations 4 and 5, the processor 400 may calculate target powers ($P_{xi}$), each defined for a predetermined set of nodes, from the calculated target OCVs ($OCV_{xi}$) and the calculated target resistance values ($R_{xi}$). In this example embodiment, the processor 400 may calculate the target powers ($P_{xi}$), each defined for the nodes ($x_i$) based on the target OCVs ($OCV_{xi}$), the target resistance values ($R_{xi}$), and the current parameters ($I_D$) in Table 1. This can be expressed according to Equation 6:

<Equation 6>

$$P_{xi} = (OCV_{xi} + R_{xi} I_D) I_D.$$

Once the target powers $P_{xi}$ are calculated according to Equation 6, the processor 400 may calculate the energy of the battery device by applying a weighted sum to the calculated target powers $P_{xi}$. The weighted sum follows the Gauss-Legendre Quadrature Rule of Equation 2.

In this example embodiment, since a weighted sum target is the target power ($P_{xi}$) and the calculation target is the battery energy, a time interval parameter may be required for the battery energy to be calculated. The time ($T_{xi}$) from a time when the SOC of the battery is the first SOC, i.e., the maximum SOC, i.e., from a discharge start time, to a time when the battery is discharged to a certain $SOC_{xi}$ may be expressed according to Equation 7 based on relationships between current, time, capacity, and SOC (in Equation 7, the capacity of the battery device is corrected by the capacity degradation parameter (facQ)).

<Equation 7>

$$T_{xi} = \frac{a \cdot Q}{I_D} \cdot \frac{facQ}{b} \cdot \frac{1}{b}(SOC_{MAX} - SOC_{xi}) = \frac{a}{b^2} \cdot \frac{Q}{I_D} \cdot facQ \cdot (SOC_{MAX} - SOC_{xi})$$

,

where a and b are unit conversion constants and have values of 36 and 100, respectively.

From Equation 7, the time ($T_{END}$) from the time when the SOC of the battery is the first SOC, i.e., the maximum SOC, i.e., from the discharge start time, to the time when the battery is discharged to the second SOC, i.e., the minimum SOC, i.e., to a discharge termination time, may be expressed according to Equation 8:

<Equation 8>

$$T_{END} = \frac{a \cdot Q}{I_D} \cdot \frac{facQ}{b} \cdot \frac{1}{b}(SOC_{MAX} - SOC_{MIN}) = \frac{a}{b^2} \cdot \frac{Q}{I_D} \cdot facQ \cdot (SOC_{MAX} - SOC_{MIN})$$

.

In embodiments, the process of calculating the battery energy (E) by applying the Gauss-Legendre Quadrature Rule to the target powers ($P_{xi}$) calculated through Equation 6 may be expressed according to Equation 9:

<Equation 9>

$$E = \frac{1}{c \cdot d} \int_{t_1=0}^{t_2=T_{END}} P(t)dt \approx \frac{1}{c \cdot d} \frac{T_{END}}{2} \sum_{i=1}^{n} w_i P_{xi}$$

where c and d are unit conversion constants and have values of 3600 and 1000, respectively.

According to Equation 9, the time-scale parameter required to calculate the battery energy (E) is equal to $T_{END}/2$. Thus, from Equation 8, the time-scale parameter ($T_{SCALE}$) may be expressed according to Equation 10:

<Equation 10>

$$T_{SCALE} = \frac{T_{END}}{2} = \frac{a}{2b^2} \cdot \frac{Q}{I_D} \cdot facQ \cdot (SOC_{MAX} - SOC_{MIN})$$

.

As a result, the time-scale parameter ($T_{SCALE}$) applied to the weighted sum method may be calculated based on the capacity (Q) of the battery device, the current parameter ($I_D$) and the capacity degradation parameter (facQ) shown in Table 1, and the first and second SOCs ($SOC_{MAX}$, $SOC_{MIN}$).

Finally, the processor 400 may apply the time-scale parameter ($T_{SCALE}$) to a resulting value obtained by applying the weighted sum method to the target powers ($P_{xi}$) to calculate energy (E) of the battery device, which can be expressed according to Equation 11:

<Equation 11>

$$E = \frac{1}{c \cdot d} \int_{0}^{T_{END}} P(t)dt \approx \frac{1}{c \cdot d} T_{SCALE} \sum_{i=1}^{n} w_i P_{xi}$$

$$= \frac{1}{c \cdot d} T_{SCALE} \sum_{i=1}^{n} w_i \cdot (OCV_{xi} \cdot I_D + R_{xi} \cdot I_D^2)$$

.

The weight ($w_i$) according to Equation 11 has an association relationship with the node setpoint ($x_i$) according to the Gauss-Legendre Quadrature Rule, in which the association relationship means that the node setpoint ($x_i$) and the weight ($w_i$) for the sample point (i) have a one-to-one correspondence with each other. The association relationship is according to Table 3.

Table 3

| $x_i$ | Node setpoint | $w_i$ | Weight |
|---|---|---|---|
| $x_1$ | 0 | $w_1$ | 0.568888888888889 |
| $x_2$ | -0.538469310105683 | $w_2$ | 0.478628670499366 |
| $x_3$ | 0.538469310105683 | $w_3$ | 0.478628670499366 |
| $x_4$ | -0.906179845938664 | $w_4$ | 0.236926885056189 |
| $x_5$ | 0.906179845938664 | $w_5$ | 0.236926885056189 |

In embodiments, the battery energy calculated according to Equation 11 may be for a single battery cell, and when a battery structure of nS battery cells connected in series or nP battery cells connected in parallel is defined as a battery system (battery module or battery pack), the total energy of the battery system may be calculated by applying at least one of nS and nP values to Equation 11, and may be expressed according to Equation 12:

<Equation 12>

$$E = \frac{nS \cdot nP}{c \cdot d} \, T_{SCALE} \sum_{i=1}^{n} w_i \cdot (OCV_{xi} \cdot I_D + R_{xi} \cdot I_D^2)$$

In addition, as described above, the relationship information, i.e., the lookup table and the first and second functions, may be obtained and stored in the memory 300 based on results of tests (in an example embodiment, GITT tests) performed on the battery device at various temperatures, and the processor 400 may be configured to read the relationship information, which corresponds to a current temperature input set through the input module 100, from the memory 300 to calculate the energy of the battery device.

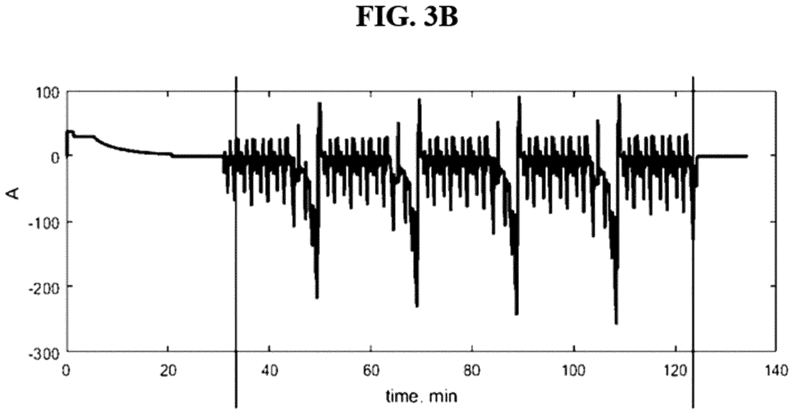

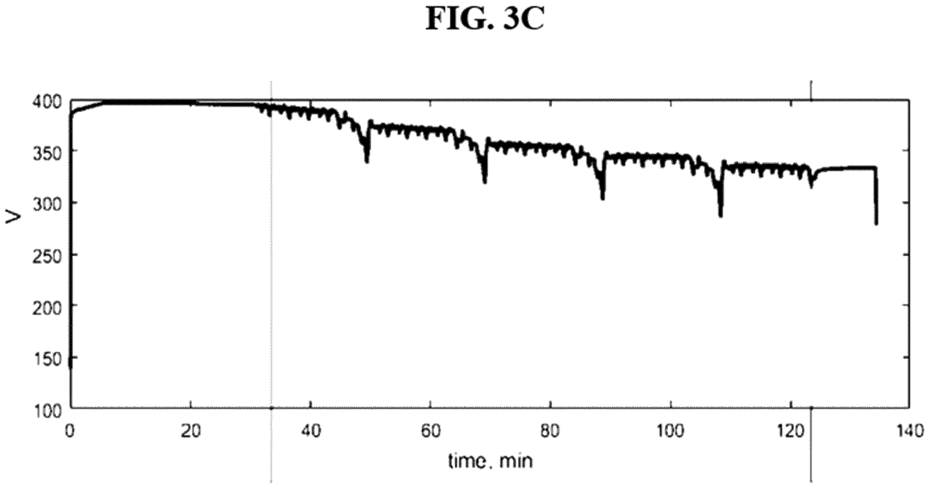

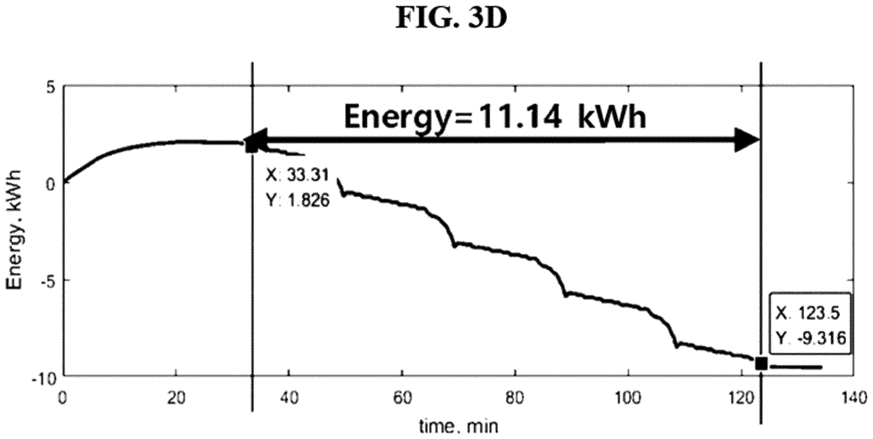

FIGs. 3A-3D illustrate the process of calculating battery energy through a typical WLTP profile. FIG. 3A is a graph showing a change in SOC, FIG. 3B is a graph showing a change in discharge current, FIG. 3C is a graph showing a change in voltage of the battery device, and FIG. 3D is a graph showing a change in battery energy. In FIG. 3A, two vertical lines corresponding to time coordinates 33.39 and 123.6 match vertical lines in FIGs. 3B-3D and indicate an SOC change range. Table 4 shows battery parameters applied to FIGs. 3A-3D and the battery energy is derived to be 11.14 kWh.

Table 4

| Battery Parameter | Value | Remark |
|---|---|---|
| First SOC ($SOC_{MAX}$) | 90% | - |
| Second SOC ($SOC_{MIN}$) | 16% | - |
| Current parameter ($I_D$) | -21.487A | - |
| Temperature (Temp) | 25°C | - |
| Capacity degradation parameter (facQ) | 87.4% | $Q_{bol}$ = 49.2Ah $Q_{cur}$ = 43Ah |
| Resistance degradation parameter (facR) | 110.64% | $R_{bol}$ = 94.9mΩ $R_{cur}$ = 105.1mΩ |
| Number of battery devices connected in series (nS) | 1 | - |
| Number of battery devices connected in parallel (nP) | 1 | - |

When the battery parameters in Table 4 used to calculate the battery energy through the WLTP profile are equally applied to Equation 12, which is adopted in this example embodiment, the battery energy is calculated to be 11.24 kWh.

When the error rate ($\varepsilon_{ENERGY}$) is defined as shown in Equation 13, the error rate of the battery energy calculation result ($E_{eq12}$) obtained through Equation 12 adopted in this example embodiment is 0.89%, as compared to the battery energy calculation result ($E_{EXPER}$) obtained through the WLTP profile, and it can be seen that reliability of the method of calculating battery energy adopted in this example embodiment can be considered quite reliable.

<Equation 13>

$$\varepsilon_{ENERGY} = \left| \frac{E_{EXPER} - E_{eq12}}{E_{EXPER}} \right| \cdot 100$$

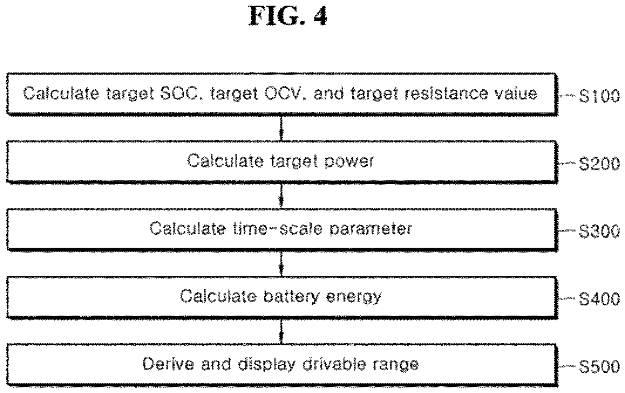

FIG. 4 is a flowchart illustrating a method of calculating battery energy according to one or more embodiments. As described above, in this example embodiment, the processor 400 may operate to calculate the energy of the battery device by simulating the process of changing the SOC of the battery device from the first SOC to the second SOC, and the method of calculating battery energy according to this example embodiment will be described with reference to FIG. 4. Detailed description of the same configuration as the above description will be omitted and the following description will focus on a time series of the configuration.

The processor 400 may first calculate target SOCs, each defined for a predetermined set of nodes, and calculate target battery characteristic information, each defined for the nodes, based on the calculated target SOCs and relationship information stored in the memory 300, i.e., relationship information between the stepwise SOC of the battery device and battery characteristic information corresponding to each stepwise SOC (S100). In this example embodiment, the battery characteristic information may include a stepwise OCV and a stepwise resistance value R corresponding to each stepwise SOC and the relationship information means information defining a relationship between each stepwise SOC, each stepwise OCV and each stepwise resistance value R. In some embodiments, each of the nodes may be assigned predefined setpoints to optimize the energy of the battery device calculated according to the weighted sum method.

In Step S100, the processor 400 may apply setpoints to a function with a first SOC, a second SOC, and nodes as arguments to calculate target SOCs, and then may apply the calculated target SOCs to the relationship information to calculate target OCVs, each defined for the nodes, and target resistance values, each defined for the nodes. In calculation of the target resistance values, the processor 400 may calculate the target resistance values based on the relationship information and a resistance degradation parameter indicating the degree of resistance degradation of the battery device.

Next, the processor 400 may calculate target powers, each defined for the nodes, from the target battery characteristic information calculated in Step S100 (S200). In this example embodiment, the processor 400 may calculate the target powers, each defined for the nodes, based on the target OCVs, the target resistance values, and a current parameter applied for changing from the first SOC to the second SOC.

Next, the processor 400 may calculate the capacity of the battery device, the current parameters applied for changing from the first SOC to the second SOC, a capacity degradation parameter indicating the degree of capacity degradation of the battery device, and a time-scale parameter applied to the weighted sum method based on the first and second SOCs (S300). Steps S200 and S300 may be performed in any order.

The processor 400 may next calculate the energy of the battery device (S400) using the weighted sum method for the plurality of target powers calculated in Step S200. In embodiments, the processor 400 may calculate the energy of the battery device by applying the time-scale parameter calculated in Step S300 to a result value obtained through application of the weighted sum method to the target powers. Weights used in the weighted sum method may be related to the setpoints assigned to the nodes according to a predefined rule (in or more embodiments, the Gauss-Legendre Quadrature Rule). In one or more embodiments, if the battery device is realized by a single battery cell and a battery structure of nS battery cells connected in series or nP battery cells connected in parallel is defined as a battery system (where nS and nP are natural numbers greater than or equal to 2), the processor 400 may apply at least one of the nS and nP values to the energy of the battery device to calculate the total energy of the battery system in Step S400.

The processor 400 may further derive a drivable range of a vehicle based on the battery energy calculated in Step S400 and display the drivable range through the output module 200 such that a user can recognize the drivable range of the vehicle at the current time (S500).

Furthermore, as multiple tests are performed at various temperatures, relationship information between the stepwise SOC of the battery device and battery characteristic information corresponding to each stepwise SOC may be stored in plural in the memory 300. Accordingly, the processor 400 may read the relationship information corresponding to the currently set temperature from the memory 300 to perform Steps S100 to S500.

The method of calculating battery energy according to one or more example embodiments may be recorded as a computer program for executing Steps S100 to S500 described above in combination with hardware, and may be stored on a non-transient computer-readable recording medium to be implemented on a general-purpose digital computer to operate the computer program. The non-transient computer-readable recording medium may be a hardware device, such as ROM, RAM, hard disks, floppy disks, magnetic media including a magnetic tape, optical media including CD-ROM and DVD, magneto-optical media including floptical disks, flash memory, etc., which may be specifically configured to store and execute program instructions.

As such, the apparatus and method according to the present disclosure can eliminate test complexity, time-consumption, and test data dependency associated with a typical method for calculating battery energy by calculating battery energy based on a simple and improved model.

It is an aspect of the present invention to provide an apparatus and method for calculating battery energy, which eliminates test complexity, time-consumption, and test data dependency associated with a typical method for calculating battery energy.

In accordance with one or more embodiments, there is provided an apparatus and method for calculating battery energy, which calculates target power based on target SOC, target OCV, and target resistance values defined for multiple nodes, followed by adding a weighted sum for the calculated target power to calculate battery energy.

As used herein, the term "module" may include a unit implemented in hardware, software, or firmware, and may be used interchangeably with terms, for example, logic, logic block, component, or circuit. A "module" may be an integrally formed part or a minimal unit or portion of the part that performs one or more functions. For example, according to one embodiment, the "module" may be implemented in the form of an Application-Specific Integrated Circuit (ASIC). In addition, the embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

**Claims**

1. An apparatus for calculating battery energy, the apparatus comprising:

   a memory (300) storing relationship information between a stepwise state of charge, SOC, of a battery device and a plurality of battery characteristic information corresponding to each stepwise SOC; and
   a processor (400) operatively coupled to the memory (300), wherein the processor (400) is configured to calculate:

   a plurality of target SOCs, each defined for a preset plurality of nodes;
   a plurality of target battery characteristic information, each defined for the plurality of nodes, based on the relationship information stored in the memory (300) and the calculated plurality of target SOCs;
   a plurality of target powers ($P_{xi}$), each defined for the plurality of nodes, from the calculated plurality of target battery characteristic information; and
   energy (E) of the battery device using a weighted sum method with respect to the plurality of target powers ($P_{xi}$) calculated above.

2. The apparatus for calculating battery energy according to claim 1, wherein the battery characteristic information includes a stepwise open circuit voltage, OCV, and a stepwise resistance value, R, corresponding to each stepwise SOC; and the relationship information defines a relationship between the stepwise SOC, the stepwise OCV, and the stepwise resistance value R.

3. The apparatus for calculating battery energy according to one of claims 1 and 2, wherein the processor (400) is configured to calculate the energy (E) of the battery device by simulating a process of changing the SOC of the battery device from a first SOC to a second SOC.

4. The apparatus for calculating battery energy according to one of the preceding claims, wherein each of the plurality of nodes is assigned a plurality of predefined setpoints ($x_i$) to optimize the energy (E) of the battery device calculated in a weighted sum method.

5. The apparatus for calculating battery energy according to claim 4, wherein the processor (400) is configured to apply the plurality of setpoints ($x_i$) to a function with the first SOC, the second SOC, and the nodes as arguments to calculate the plurality of target SOCs, and to apply the calculated plurality of target SOCs to the relationship information to calculate a plurality of target OCVs, each defined for the plurality of nodes, and a plurality of target resistance values Rs, each defined for the plurality of nodes.

6. The apparatus for calculating battery energy according to claim 5, wherein the processor (400) is configured to calculate the target resistance values based on the relationship information and a resistance degradation parameter (facR) indicating a degree of resistance degradation of the battery device.

7. The apparatus for calculating battery energy according to one of claims 5 and 6, wherein the processor (400) is configured to calculate the plurality of target powers ($P_{xi}$), each defined for the plurality of nodes, based on the plurality of target OCVs, the plurality of target resistance values Rs, and a current parameter ($I_D$) applied to change the SOC of the battery device from the first SOC to the second SOC.

8. The apparatus for calculating battery energy according to one of claims 5 to 7, wherein the processor (400) is configured to calculate a capacity of the battery device, a current parameter applied to change the SOC of the battery device from the first SOC to the second SOC, a capacity degradation parameter indicating a degree of capacity degradation of the battery device, and a time-scale parameter applied to the weighted sum method based on the first and second SOCs.

9. The apparatus for calculating battery energy according to claim 8, wherein the processor (400) is configured to calculate the energy (E) of the battery device by applying the time-scale parameter to a result value obtained through application of the weighted sum method to the plurality of target powers ($P_{xi}$).

10. The apparatus for calculating battery energy according to one of the preceding claims, wherein each of the plurality of nodes is assigned a plurality of predefined setpoints ($x_i$) to optimize the energy (E) of the battery device calculated in the weighted sum method, and the setpoints ($x_i$) assigned to the nodes and weights applied to the weighted sum method have a relationship according to a predefined rule.

11. The apparatus for calculating battery energy according to one of the preceding claims, wherein, if the battery device is realized by a single battery cell, and, when a battery structure of nS battery cells connected in series or nP battery cells connected in parallel is defined as a battery system, nS and nP being natural numbers greater than or equal to 2, the processor (400) is adapted to apply at least one of nS and nP values to the calculated energy of the battery device to calculate a total energy of the battery system.

12. The apparatus for calculating battery energy according to one of the preceding claims, wherein the memory (300) is adapted to store the relationship information obtained based on a result of a test performed on the battery device at a particular temperature and including a plurality of relationship information based on results of a plurality of tests performed at a plurality of temperatures, and the processor (400) is adapted to read the relationship information corresponding to a currently set temperature from the memory (300) to calculate the energy (E) of the battery device.

13. A method of calculating battery energy with an apparatus as defined in one of the preceding claims, the method comprising:

calculating, by the processor (400), a plurality of target SOCs, each defined for a preset plurality of nodes, and a plurality of target battery characteristic information each defined for the plurality of nodes and based on the calculated plurality of target SOCs and relationship information, the relationship information defining a relationship between a stepwise state of charge (SOC) of a battery device and a plurality of battery characteristic information corresponding to each stepwise SOC;
calculating, by the processor (400), a plurality of target powers ($P_{xi}$), each defined for the plurality of nodes, from the calculated plurality of target battery characteristic information; and
calculating, by the processor (400), energy (E) of the battery device using a weighted sum method for the calculated plurality of target powers ($P_{xi}$).

14. A computer program recorded in a non-transient computer-readable storage medium to execute, in combination with hardware, a computer program, comprising:

calculating a plurality of target SOCs, each defined for a preset plurality of nodes, and a plurality of target battery characteristic information each defined for the plurality of nodes and based on the calculated plurality of target SOCs and relationship information, the relationship information defining a relationship between a stepwise state of charge (SOC) of a battery device and a plurality of battery characteristic information corresponding to each stepwise SOC;

calculating a plurality of target powers ($P_{xi}$), each defined for the plurality of nodes, from the calculated plurality of target battery characteristic information; and

calculating energy (E) of the battery device using a weighted sum method for the calculated plurality of target powers ($P_{xi}$).

# FIG. 1

# FIG. 2

## FIG. 3A

EP 4 571 337 A1

## FIG. 3B

EP 4 571 337 A1

# FIG. 3C

FIG. 3D

# FIG. 4

| | |
|---|---|
| Calculate target SOC, target OCV, and target resistance value | ～S100 |
| Calculate target power | ～S200 |
| Calculate time-scale parameter | ～S300 |
| Calculate battery energy | ～S400 |
| Derive and display drivable range | ～S500 |

**EUROPEAN SEARCH REPORT**

Application Number

EP 24 16 9683

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | REN DONGSHENG ET AL: "Battery remaining discharge energy estimation based on prediction of future operating conditions", JOURNAL OF ENERGY STORAGE, [Online] vol. 25, October 2019 (2019-10), page 100836, XP093216455, DOI: 10.1016/j.est.2019.100836 Retrieved from the Internet: URL:https://www.sciencedirect.com/science/article/pii/S2352152X19303366?casa_token=1 CoridOF7-wAAAAA:4P0ACPkULKu955mge241NUGOW1 eLgTRTfpE3gTZi8NnJfST1jlVT8FjyQ6hHShN6uJ21 4uW5#fig0015> [retrieved on 2024-10-18] * figures 2,3,5 * * equation 5; page 3 * * 2. ERDE estimation method based on the prediction of future operating conditions; page 3 * * equations 6 and 14-23; page 4 * * 2.1 Future power output and future temperature prediction; page 3 * * 3.1. Reference performance tests; page 5 * * sentence before 3.2. Dynamic loading profiles tests at different temperatures; page 5 * * 3.2. Dynamic loading profiles tests at different temperatures; page 5 * * Conclusions; page 10 * ----- -/-- | 1-14 | INV. G01R31/367 G01R31/3842 G01R31/389 G01R31/392 G01R31/396 H01M10/48 H02J7/00 TECHNICAL FIELDS SEARCHED (IPC) G01R H01M B60L |

The present search report has been drawn up for all claims

| Place of search | Date of completion of the search | Examiner |
|---|---|---|
| The Hague | 21 October 2024 | Rambaud, Patrick |

EPO FORM 1503 03.82 (P04C01)

Europäisches
Patentamt

European
Patent Office

Office européen
des brevets

**EUROPEAN SEARCH REPORT**

Application Number

EP 24 16 9683

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 8 185 332 B2 (KANG JUNG-SOO [KR]; KIM JU-YOUNG [KR]; LG CHEMICAL LTD [KR]) 22 May 2012 (2012-05-22) * claim 15 * | 6 | |
| A | US 2022/308115 A1 (KOKETSU SEIICHI [JP] ET AL) 29 September 2022 (2022-09-29) * claim 1 * | 8,9 | |
| A | US 10 078 116 B2 (YOSHIDA TADAHIRO [JP]; NEC ENERGY DEVICES LTD [JP]) 18 September 2018 (2018-09-18) * figure 4 * * claim 1 * | 1-14 | |

TECHNICAL FIELDS
SEARCHED       (IPC)

The present search report has been drawn up for all claims

| Place of search | Date of completion of the search | Examiner |
|---|---|---|
| The Hague | 21 October 2024 | Rambaud, Patrick |

EPO FORM 1503 03.82 (P04C01)

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.......................................................................
& : member of the same patent family, corresponding
    document

page 2 of 2

## ANNEX TO THE EUROPEAN SEARCH REPORT
## ON EUROPEAN PATENT APPLICATION NO.

EP 24 16 9683

This annex lists the patent family members relating to the patent documents cited in the above-mentioned European search report.
The members are as contained in the European Patent Office EDP file on
The European Patent Office is in no way liable for these particulars which are merely given for the purpose of information.

21-10-2024

| Patent document cited in search report | | Publication date | Patent family member(s) | | Publication date |
|---|---|---|---|---|---|
| US 8185332 | B2 | 22-05-2012 | BR | PI0912595 A2 | 13-10-2015 |
| | | | CN | 102124354 A | 13-07-2011 |
| | | | EP | 2325658 A1 | 25-05-2011 |
| | | | JP | 5661625 B2 | 28-01-2015 |
| | | | JP | 2011530709 A | 22-12-2011 |
| | | | KR | 100927541 B1 | 17-11-2009 |
| | | | TW | 201007191 A | 16-02-2010 |
| | | | US | 2010042345 A1 | 18-02-2010 |
| | | | US | 2011256434 A1 | 20-10-2011 |
| | | | WO | 2010018919 A1 | 18-02-2010 |
| US 2022308115 | A1 | 29-09-2022 | CN | 115128491 A | 30-09-2022 |
| | | | JP | 7235792 B2 | 08-03-2023 |
| | | | JP | 2022147889 A | 06-10-2022 |
| | | | US | 2022308115 A1 | 29-09-2022 |
| US 10078116 | B2 | 18-09-2018 | CN | 104145190 A | 12-11-2014 |
| | | | JP | 6138757 B2 | 31-05-2017 |
| | | | JP | WO2013128811 A1 | 30-07-2015 |
| | | | US | 2015025825 A1 | 22-01-2015 |
| | | | US | 2018372803 A1 | 27-12-2018 |
| | | | WO | 2013128811 A1 | 06-09-2013 |